# EUROPÄISCHE PATENTSCHRIFT

(11) **EP 3 571 447 B1**
(45) Veröffentlichungstag und Bekanntmachung des Hinweises auf die Patenterteilung: **05.07.2023**
(21) Anmeldenummer: 18709780.3
(22) Anmeldetag: 12.02.2018
(51) Int. Cl.: F24H 1/18, F24H 1/20

(54) **VORRICHTUNG ZUM HEIZEN ODER KÜHLEN EINES WOHNRAUMS**
DEVICE FOR HEATING OR COOLING A LIVING SPACE
DISPOSITIF POUR CHAUFFER OU REFROIDIR UNE PIÈCE À VIVRE

(30) Priorität: 11.02.2017 CH 1902017
(43) Veröffentlichungstag der Anmeldung: 27.11.2019
(73) Patentinhaber: Zehnder Group International AG, 5722 Gränichen (CH)
(72) Erfinder: LEFFERING, Christian, 8032 Zürich (CH); EGGERT, Dominik, 8046 Zürich (CH); WERNER, Uwe, 8825 Hütten (CH); LÖRTSCHER, Luca, 8630 Rüti (CH)
(74) Vertreter: Rentsch Partner AG
(86) Internationale Anmeldenummer: PCT/IB2018/050847
(87) Internationale Veröffentlichungsnummer: WO 2018/146646

(56) Entgegenhaltungen:
- WO-A1-2010/133814
- WO-A1-2011/152784
- DE-A1-102012 206 127
- GB-A- 2 278 934

## Beschreibung

Die Erfindung bezieht sich auf eine Vorrichtung zum Heizen oder Kühlen eines Wohnraumes.

Derartige Vorrichtungen, auch Temperierkörper zum Heizen oder Kühlen genannt, sind bekannt. Es gibt z.B. elektrische Varianten, bei denen der Temperierkörper elektrisch (resistiv) aufgeheizt oder (thermoelektrisch) gekühlt wird. Andererseits gibt es hydronische Varianten, bei denen der Temperierkörper von einem Wärmeträgerfluid durchströmt wird, dessen Temperatur je nach Bedarf (Heizen oder Kühlen) ausreichend hoch über oder ausreichend tief unter der Umgebungstemperatur bzw. der Lufttemperatur des Wohnraumes liegt.

GB 2 278 934 offenbart ein Steuermodul für ein Stellglied, z.B. für ein Ventil in einem Zentralheizungssystem, das eine eigene Energiequelle, lokale Eingabemittel und Mittel zur Fernkommunikation mit einem zentralen Steuersystem vorzugsweise ohne Kabel umfasst. Die Energiequelle kann eine Batterie oder ein thermoelektrischer Generator sein, der den Seebeck-Effekt nutzt.

DE 10 2012 206 127 offenbart eine thermoelektrische Vorrichtung zur Erzeugung von elektrischer Energie aus Wärme, insbesondere für den Einsatz in einem Kraftfahrzeug, mit mindestens einem ersten thermoelektrisches Modul, welches eine erste Oberfläche aufweist und eine zweite der ersten Oberfläche gegenüberliegend angeordnete Oberfläche aufweist, mit einem ersten Strömungskanal für ein erstes Fluid und einem zweiten Strömungskanal für ein zweites Fluid, wobei zwischen dem ersten Fluid und dem zweiten Fluid eine Temperaturdifferenz besteht. Die erste Oberfläche steht mit dem ersten Strömungskanal in thermisch leitender Verbindung und die zweite Oberfläche steht mit dem zweiten Strömungskanal in thermisch leitender Verbindung. Der erste Strömungskanal steht an einem seiner Enden mit einem ersten Sammler in Fluidkommunikation und mit seinem anderen Ende mit einem zweiten Sammler in Fluidkommunikation. Der zweite Strömungskanal steht mit einem seiner Enden mit einem dritten Sammler in Fluidkommunikation und mit seinem anderen Ende mit einem vierten Sammler in Fluidkommunikation.

Für den bedarfsgerechten Heiz- oder Kühlbetrieb derartiger Vorrichtungen sind Sensoren und Aktoren erforderlich, die elektrische Energie benötigen.

Der Erfindung liegt die Aufgabe zugrunde, eine Vorrichtung zum Heizen oder Kühlen eines Wohnraumes bereitzustellen, die mit möglichst geringem elektrischem Installationsaufwand in einem Wohnraum installiert werden kann.

Zur Lösung dieser Aufgabe wird durch die Erfindung eine Vorrichtung zum Heizen oder Kühlen eines Wohnraumes bereitgestellt, mit einem von einem Wärmeträgerfluid, vorzugsweise Wasser, durchströmbaren Körper, welcher eine Vorlaufleitung zum Einleiten von Wärmeträgerfluid in den Körper sowie eine Rücklaufleitung zum Ausleiten von Wärmeträgerfluid aus dem Körper aufweist, wobei die Vorrichtung erfindungsgemäss mindestens einen thermoelektrischen Generator mit einem Hochtemperatur-Ende und einem Niedertemperatur-Ende aufweist, und wobei der mindestens eine thermoelektrische Generator zwischen der Vorlaufleitung und der Rücklaufleitung der Vorrichtung geschaltet ist. Dadurch kann der thermoelektrische Generator die relativ grosse Temperaturdifferenz zwischen der Vorlaufleitung und der Rücklaufleitung sowohl im Heizfall als auch im Kühlfall zur Erzeugung elektrischer Energie nutzen.

Erfindungsgemäß hat die Vorrichtung einen thermoelektrischen Generator TEG1, dessen Hochtemperatur-Ende mit der Vorlaufleitung in thermischem Kontakt ist und dessen

Niedertemperatur-Ende mit der Rücklaufleitung in thermischem Kontakt ist. Dadurch kann der TEG1 im Heizfall elektrische Energie erzeugen.

Vorzugsweise hat die Vorrichtung einen weiteren thermoelektrischen Generator TEG2, dessen Hochtemperatur-Ende mit der Rücklaufleitung in thermischem Kontakt ist und dessen Niedertemperatur-Ende mit der Vorlaufleitung in thermischem Kontakt ist. Dadurch kann der TEG2 im Kühlfall elektrische Energie erzeugen.

Zweckmässigerweise hat die Vorlaufleitung einen Vorlauf-Teilabschnitt und die Rücklaufleitung einen Rücklauf-Teilabschnitt, wobei der mindestens eine thermoelektrische Generator zwischen dem Vorlauf-Teilabschnitt und dem Rücklauf-Teilabschnitt geschaltet ist.

Vorzugsweise haben der Vorlauf-Teilabschnitt und der Rücklauf-Teilabschnitt voneinander einen kleineren Abstand als andere Abschnitte der Vorlaufleitung und der Rücklaufleitung voneinander. Dadurch sind die Entfernungen, welche der Wärmefluss zwischen einem jeweiligen Teilabschnitt der Rücklaufleitung und der Vorlaufleitung und einem jeweiligen Anschluss des thermoelektrischen Generators, besonders kurz, wodurch die jeweilige Temperaturdifferenz über diese Entfernungen besonders klein sind und somit praktisch die gesamte Temperaturdifferenz ohne nennenswerten Verlust an dem thermoelektrischen Generator anliegt.

Vorzugsweise ist zwischen dem Vorlauf-Teilabschnitt und dem thermoelektrischen Generator ein erstes wärmeleitendes Adapterglied in thermischer Kopplung angeordnet und zwischen dem Rücklauf-Teilabschnitt und dem thermoelektrischen Generator ein zweites wärmeleitendes Adapterglied in thermischer Kopplung angeordnet. Vorzugsweise enthalten die wärmeleitenden Adapterglieder Materialien wie Kupfer, Messing oder Graphit. Besonders bevorzugt ist expandierter Graphit mit Bikomponenten-Fasern (Biko-Fasern), wenn die Vorlaufleitung und die Rücklaufleitung aus Polymermaterial gebildet sind. Zweckmässigerweise weisen die Biko-Fasern an ihrer Oberfläche ein Oberflächen-Polymermaterial auf, dessen Schmelzpunkt nahe beim Schmelzpunkt des Polymermaterials der Vorlaufleitung und der Rücklaufleitung liegt, während der Kern der Biko-Fasern ein Kern-Polymermaterial aufweist, dessen Schmelzpunkt höher als der Schmelzpunkt des Oberflächen-Polymermaterials ist. Vorzugsweise ist das Oberflächen-Polymermaterial der Biko-Fasern dasselbe Material wie das Polymermaterial der Vorlauf- und Rücklaufleitung. Durch kurzfristiges Erreichen oder Überschreiten der Schmelztemperatur des Oberflächen-Polymermaterials verschmelzen die Biko-Fasern mit dem Polymermaterial der Vorlauf- und Rücklaufleitung, wodurch eine innige mechanische und thermische Verbindung zwischen der Vorlauf- und Rücklaufleitung und dem Verbundmaterial aus expandiertem Graphit und Biko-Fasern der beiden Adapterglieder erzielt wird.

Zweckmässigerweise ist das erste und/oder das zweite wärmeleitende Adapterglied in einer seiner Abmessungen längenverstellbar. Dies ermöglicht die Anpassung an verschiedene Abstände zwischen der Vorlaufleitung und der Rücklaufleitung.

Zweckmässigerweise hat der Vorlauf-Teilabschnitt eine Vorlauf-Formation und das erste wärmeleitende Adapterglied eine zu der Vorlauf-Formation komplementäre erste Adapter-Formation, während der Rücklauf-Teilabschnitt eine Rücklauf-Formation hat und das zweite wärmeleitende Adapterglied eine zu der Rücklauf-Formation komplementäre zweite Adapter-Formation hat. Dadurch erreicht man eine gute thermische Verbindung zwischen der Vorlauf- und Rücklaufleitung und den beiden Adaptergliedern.

Vorzugsweise haben das erste wärmeleitende Adapterglied eine zu dem Hochtemperatur-Ende komplementäre Formation und das zweite wärmeleitende Adapterglied eine zu dem Niedertemperatur-Ende komplementäre Formation. Erfindungsgemäß hat der mindestens eine thermoelektrische Generator einen elektrisch positiven Anschluss und einen elektrisch negativen Anschluss, wobei zwischen dem positiven Anschluss und dem negativen Anschluss mindestens ein elektrischer Verbraucher geschaltet ist. Erfindungsgemäß wird als der mindestens eine Verbraucher ein Sensor verwendet, wobei der Sensor einen Drucksensor und/oder einen Temperatursensor umfasst.

Als weiterer elektrischer Verbraucher können zusätzlich z.B. ein Ventil-Stellantrieb, ein Akkumulator, etc. angeschlossen sein.

Vorzugsweise wird als mindestens ein elektrischer Verbraucher zusätzlich mindestens eines der folgenden Elemente verwendet: ein Funksender, ein Funkempfänger, ein Aktuator, ein elektrischer Speicher, ein Spannungswandler oder eine Steuerungsschaltung.

Zweckmässigerweise enthält die Vorrichtung ein Ventil, das in der Vorlaufleitung oder in der Rücklaufleitung geschaltet ist.

Bei einer besonders bevorzugten Ausführung ist der thermoelektrische Generator in eine Baueinheit integriert, welche einen Vorlauf-Einlassanschluss, einen Vorlauf-Auslassanschluss, einen Rücklauf-Einlassanschluss und einen Rücklauf-Auslassanschluss aufweist, wobei die Baueinheit mittels ihrer Anschlüsse in der Vorlaufleitung und in der Rücklaufleitung geschaltet ist. Das Ventil kann in die Baueinheit 10 integriert sein.

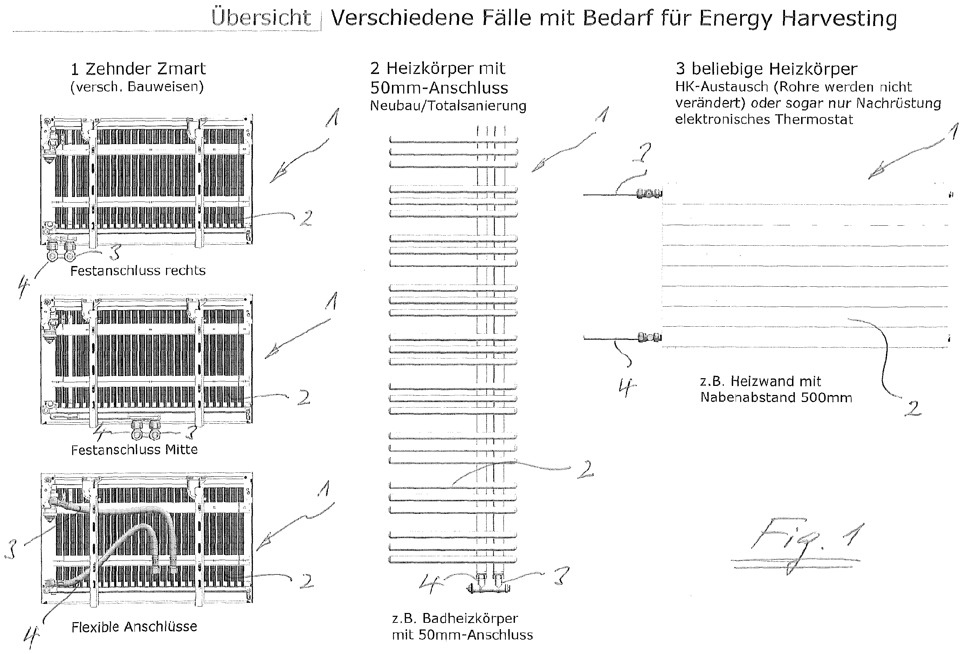

Weitere Vorteile, Merkmale und Anwendungsmöglichkeiten der Erfindung ergeben sich aus der nun folgenden, nicht einschränkend aufzufassenden Beschreibung von Ausführungsbeispielen der Erfindung anhand der Zeichnung, wobei
Fig. 1 Vorrichtungen zum Heizen oder Kühlen des Stands der Technik zeigt;

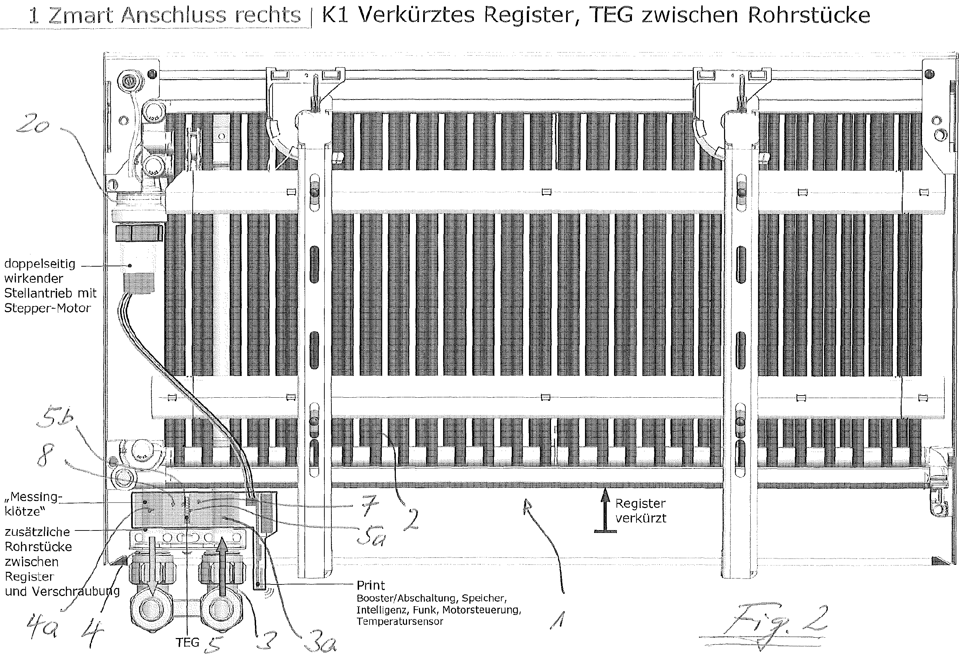

Fig. 2 eine erste Ausführung der erfindungsgemässen Vorrichtung zeigt;

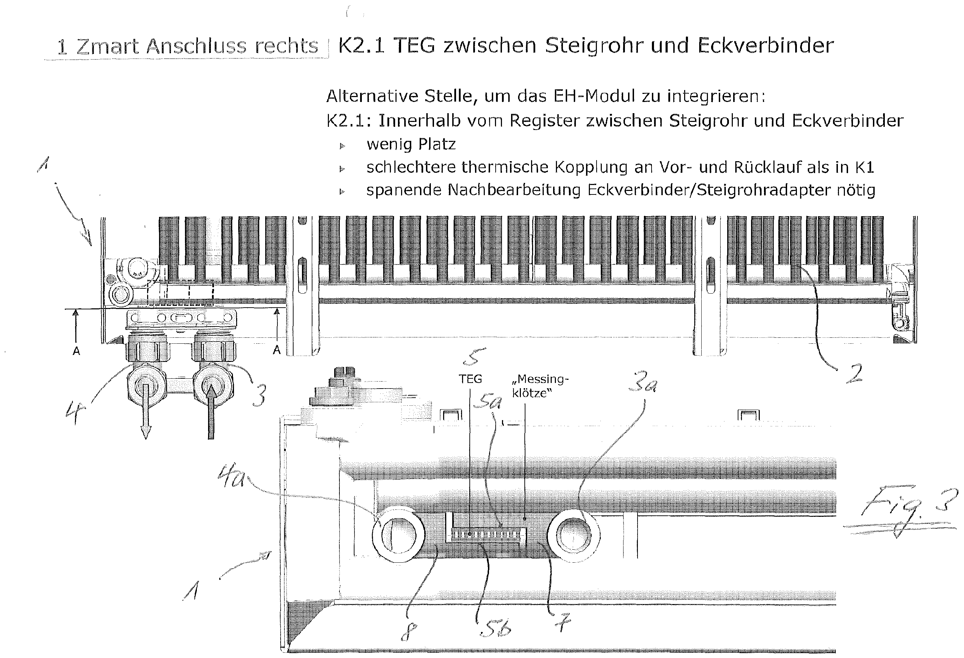

Fig. 3 eine zweite Ausführung der erfindungsgemässen Vorrichtung zeigt;

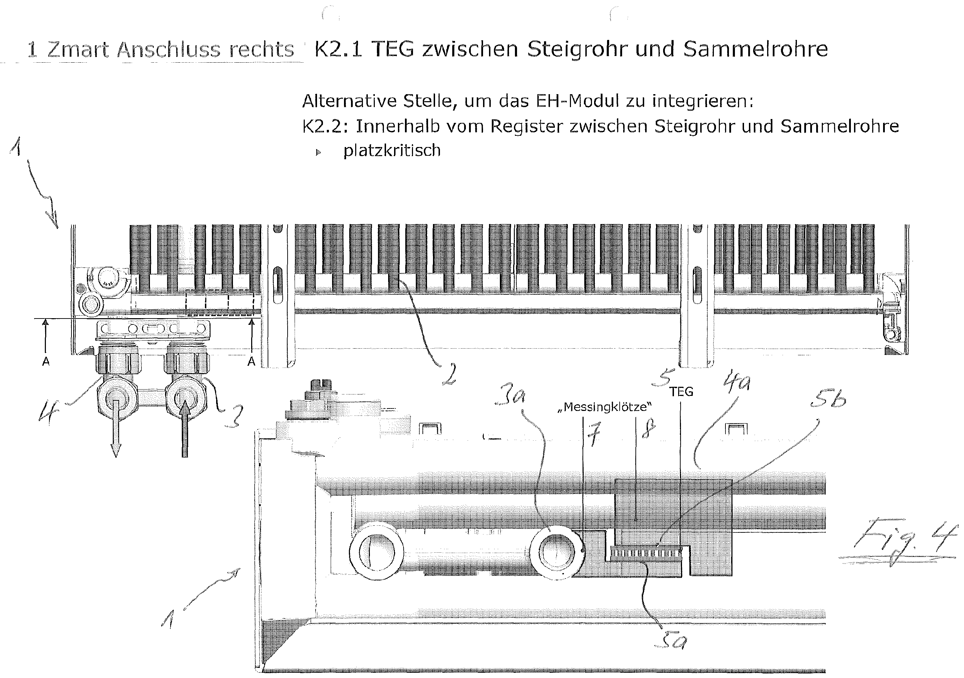

Fig. 4 eine dritte Ausführung der erfindungsgemässen Vorrichtung zeigt;

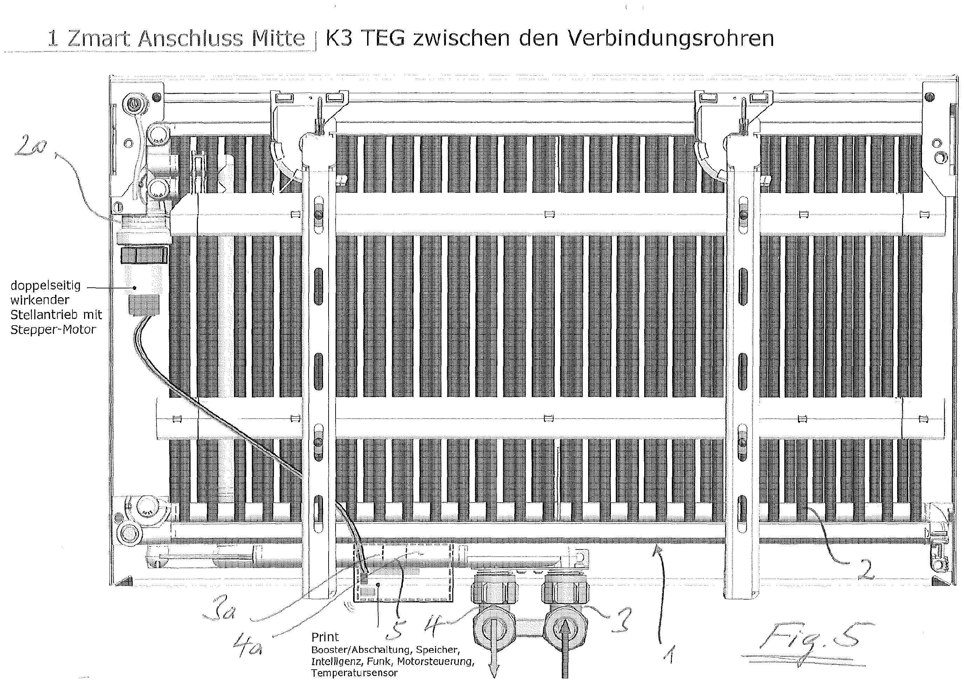

Fig. 5 eine vierte Ausführung der erfindungsgemässen Vorrichtung in einer ersten Ansicht zeigt;

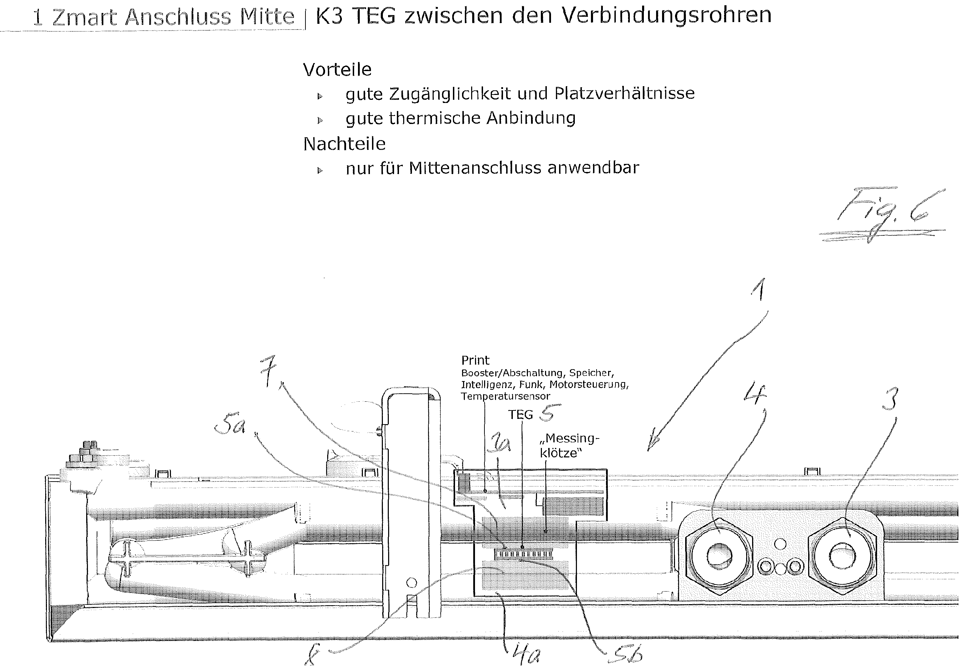

Fig. 6 die vierte Ausführung der erfindungsgemässen Vorrichtung in einer zweiten Ansicht zeigt;

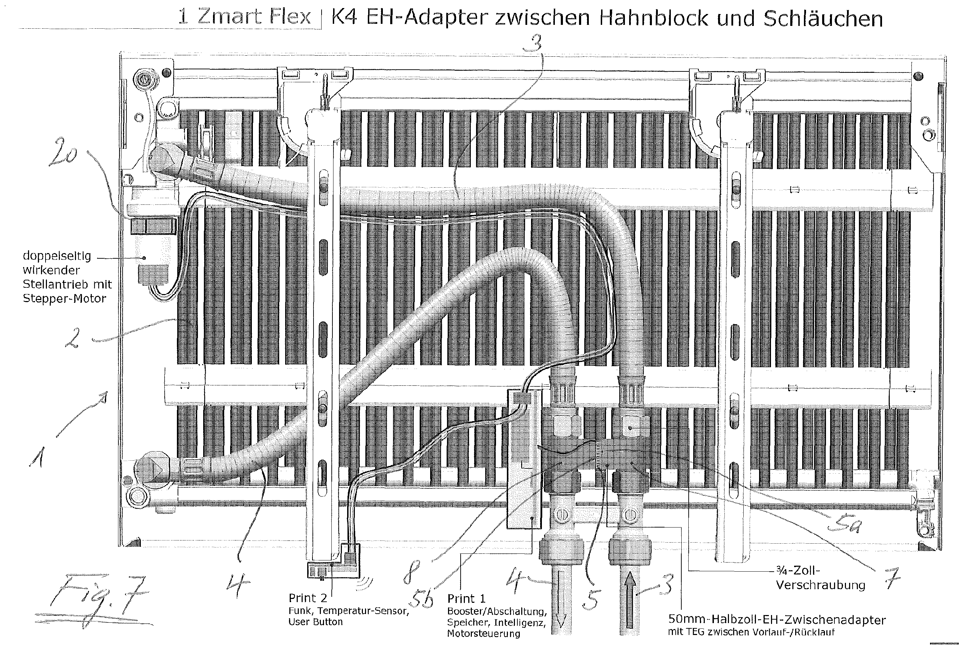

Fig. 7 eine fünfte Ausführung der erfindungsgemässen Vorrichtung zeigt;

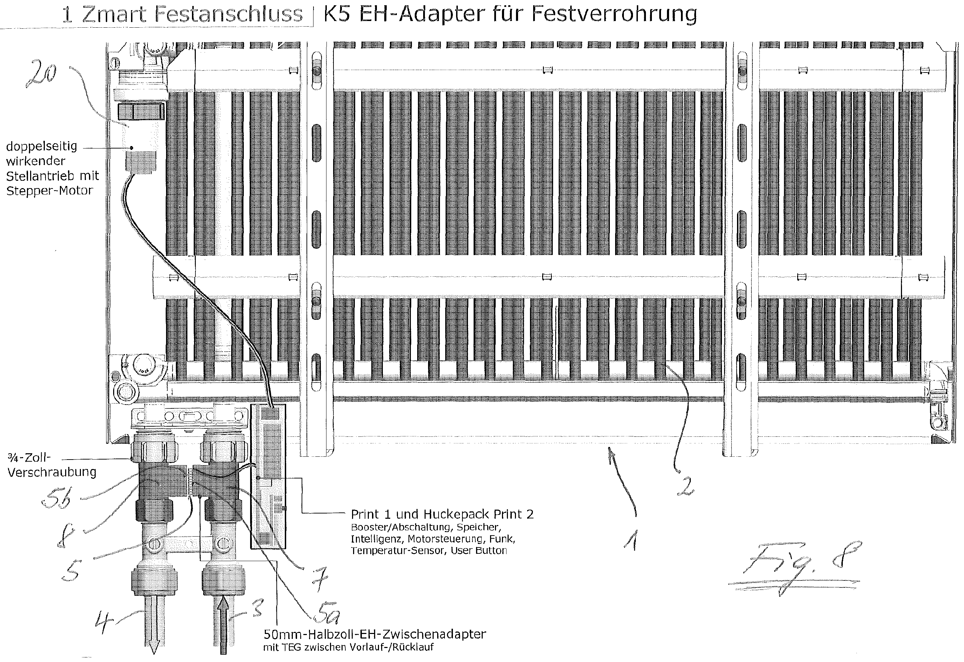

Fig. 8 eine sechste Ausführung der erfindungsgemässen Vorrichtung zeigt;

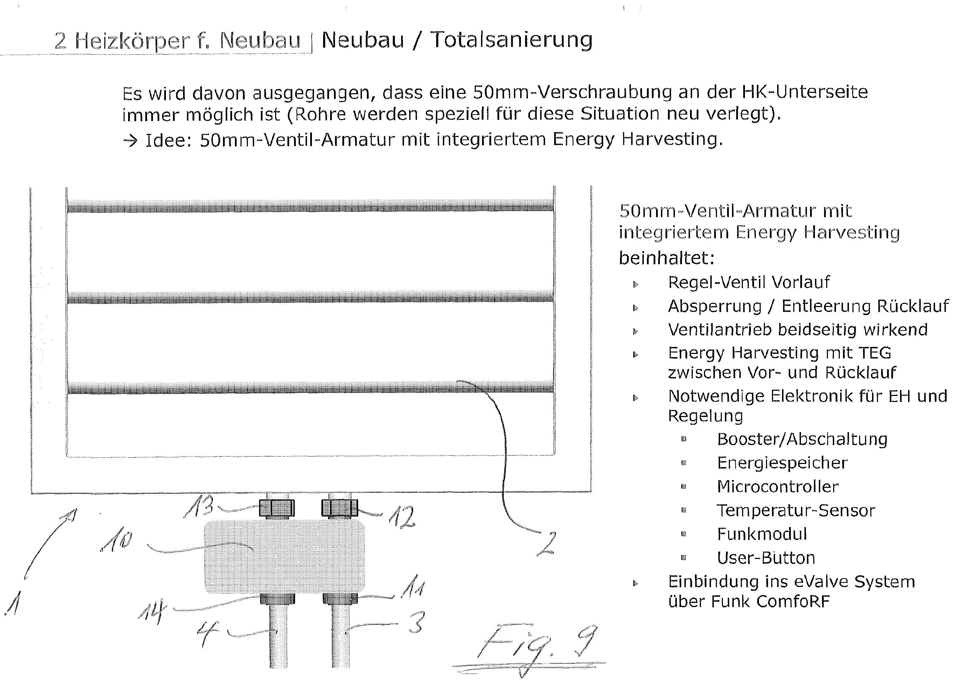

Fig. 9 eine siebte Ausführung der erfindungsgemässen Vorrichtung mit einer erfindungsgemässen Baueinheit in einer ersten Ansicht zeigt;

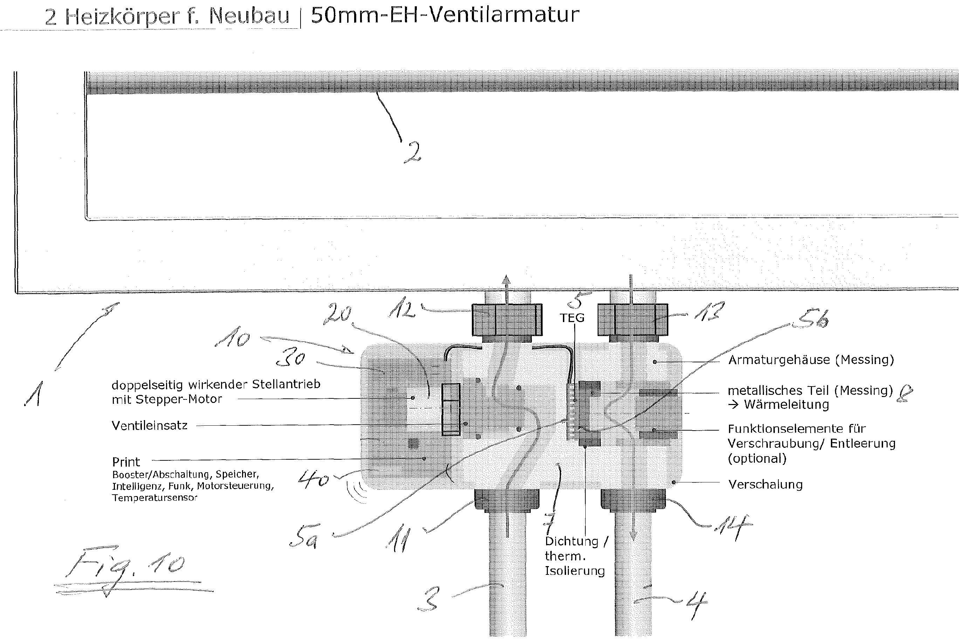

Fig. 10 die siebte Ausführung der erfindungsgemässen Vorrichtung mit der erfindungsgemässen Baueinheit in einer zweiten Ansicht zeigt;
Fig. 11 die erfindungsgemässe Baueinheit zeigt;

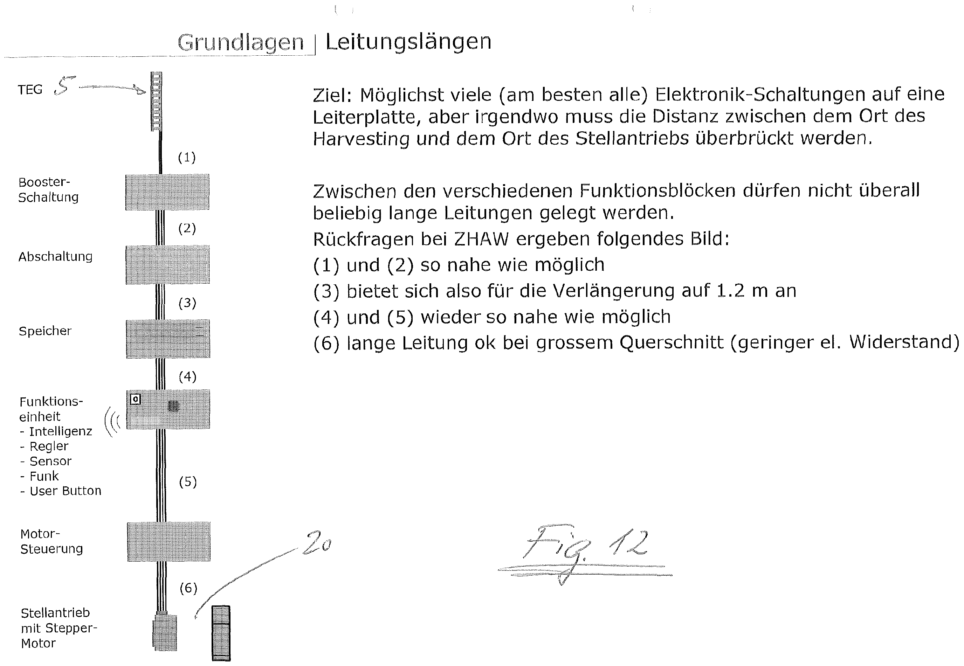

Fig. 12 eine schematische Darstellung der Schaltung elektrischer Verbraucher ist;

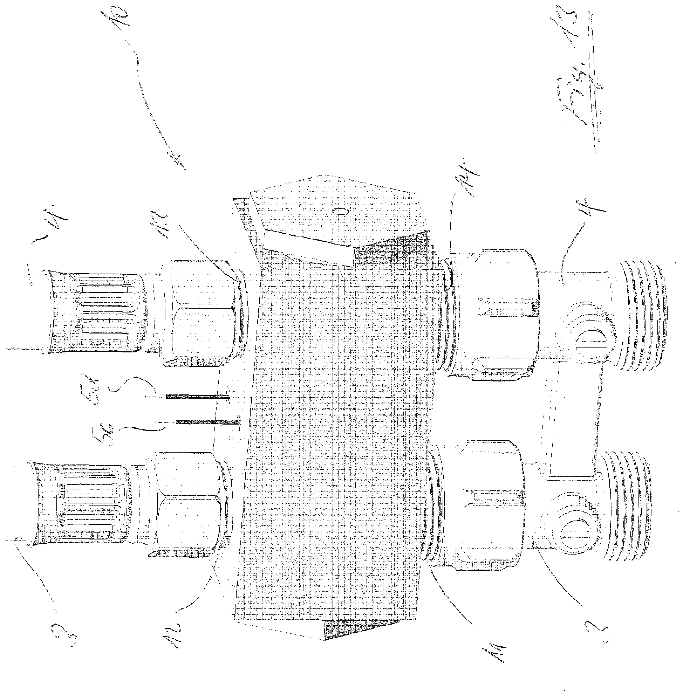

Fig. 13 eine Perspektivansicht einer Ausführung der erfindungsgemässen Baueinheit ist;

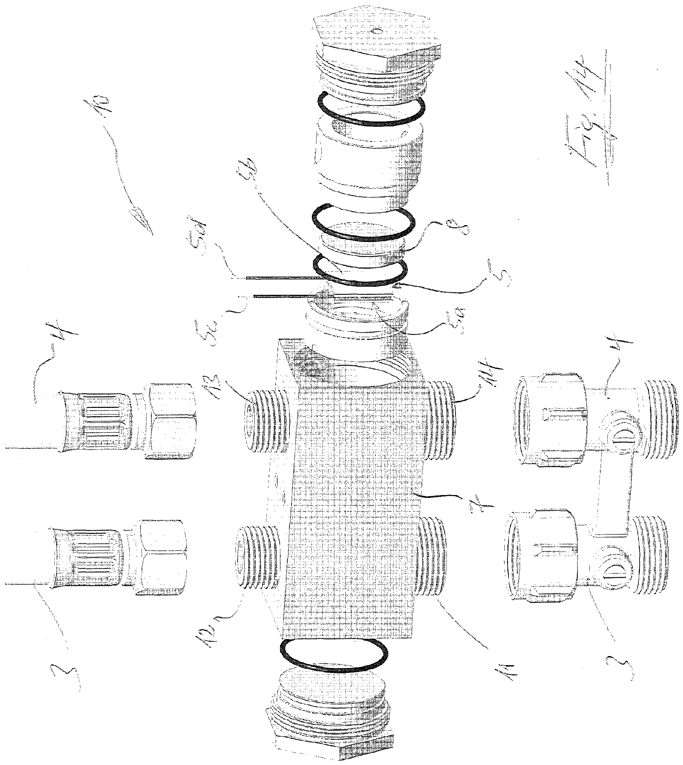

Fig. 14 eine Explosionsansicht von Fig. 13 ist;

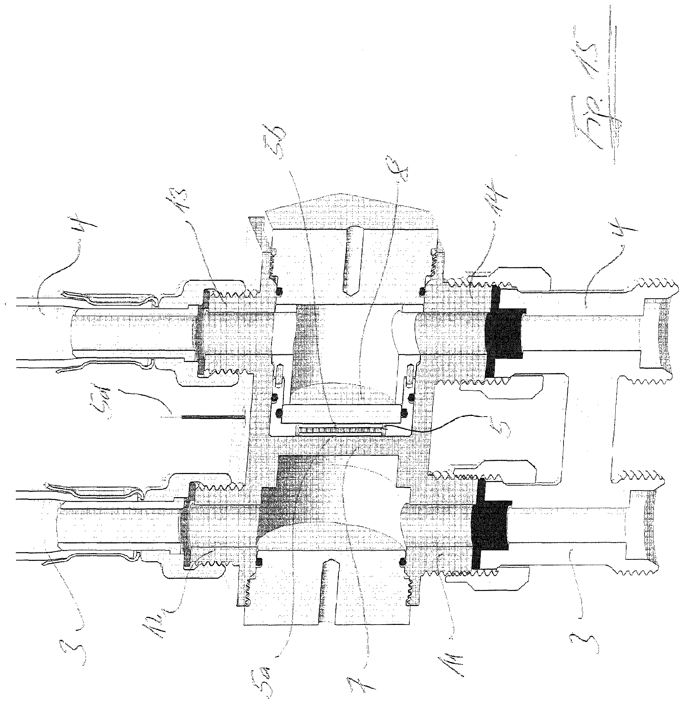

Fig. 15 eine Schnittansicht der erfindungsgemässen Baueinheit von Fig. 13 ist; und

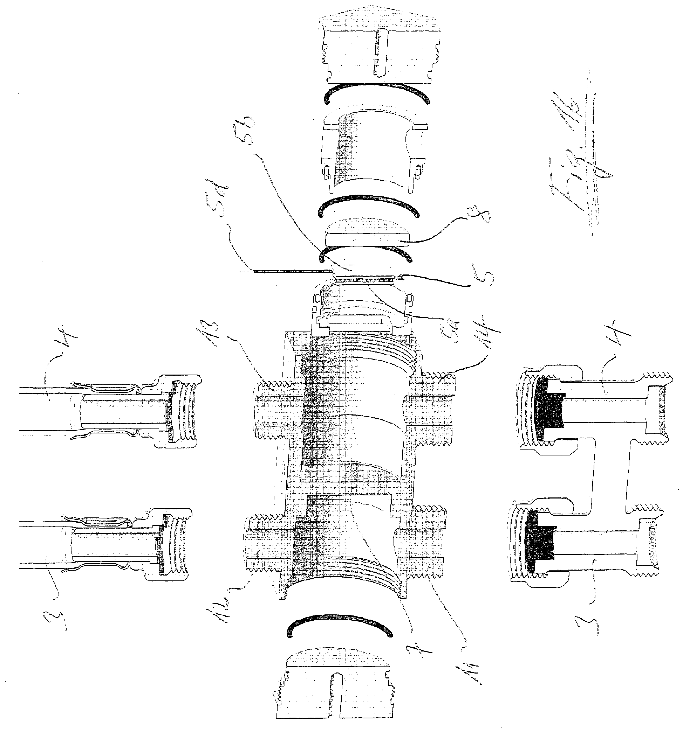

Fig. 16 eine Explosionsansicht von Fig. 15 ist.

Man erkennt in der Zeichnung die schematisch dargestellte Vorrichtung 1. Sie kann zum Heizen oder Kühlen eines Wohnraumes verwendet werden. Die Vorrichtung 1 enthält einen von einem Wärmeträgerfluid, vorzugsweise Wasser, durchströmbaren Körper 2, welcher mit einer Vorlaufleitung 3 zum Einleiten von Wärmeträgerfluid in den Körper sowie einer Rücklaufleitung 4 zum Ausleiten von Wärmeträgerfluid aus dem Körper 2 verbunden ist. Die Vorrichtung 1 enthält einen thermoelektrischen Generator 5 mit einem Hochtemperatur-Ende 5a und einem Niedertemperatur-Ende 5b. Der thermoelektrische Generator 5 ist zwischen der Vorlaufleitung 3 und der Rücklaufleitung 4 geschaltet. Das Hochtemperatur-Ende 5a ist mit der Vorlaufleitung 3 in thermischem Kontakt. Das Niedertemperatur-Ende 5b ist mit der Rücklaufleitung 4 in thermischem Kontakt.

Die Vorrichtung 1 kann einen weiteren thermoelektrischen Generator (6, nicht gezeigt) aufweisen, dessen Hochtemperatur-Ende (6a, nicht gezeigt) mit der Rücklaufleitung 4 in thermischem Kontakt ist und dessen Niedertemperatur-Ende (6b, nicht gezeigt) mit der Vorlaufleitung 3 in thermischem Kontakt ist.

Die Vorlaufleitung 3 enthält einen Vorlauf-Teilabschnitt 3a, und die Rücklaufleitung 4 enthält einen Rücklauf-Teilabschnitt 4a. Der thermoelektrische Generator 5 ist thermisch zwischen dem Vorlauf-Teilabschnitt 3a und dem Rücklauf-Teilabschnitt 4a geschaltet ist. Der Vorlauf-Teilabschnitt 3a und der Rücklauf-Teilabschnitt 4a haben voneinander einen kleineren Abstand als andere Abschnitte der Vorlaufleitung 3 und der Rücklaufleitung 4 voneinander.

Zwischen dem Vorlauf-Teilabschnitt 3a und dem thermoelektrischen Generator 5 ist ein erstes wärmeleitendes Adapterglied 7 in thermischer Kopplung angeordnet. Zwischen dem Rücklauf-Teilabschnitt 4a und dem thermoelektrischen Generator 5 ist ein zweites wärmeleitendes Adapterglied 8 in thermischer Kopplung angeordnet. Das Adapterglied enthält z.B. eines der folgenden Materialien: Kupfer, Messing, Graphit, und insbesondere expandierten Graphit mit Biko-Fasern, falls der die Vorlaufleitung 3 und die Rücklaufleitung 4 aus Polymermaterial bestehen.

Das erste und/oder das zweite wärmeleitende Adapterglied 7, 8 kann in einer seiner Abmessungen längenverstellbar sein.

Der Vorlauf-Teilabschnitt 3a hat eine Vorlauf-Formation und das erste wärmeleitende Adapterglied 7 eine zu der Vorlauf-Formation komplementäre erste Adapter-Formation. Der Rücklauf-Teilabschnitt 4a hat eine Rücklauf-Formation und das zweite wärmeleitende Adapterglied 8 eine zu der Rücklauf-Formation komplementäre zweite Adapter-Formation.

Das erste wärmeleitende Adapterglied 7 hat eine zu dem Hochtemperatur-Ende 5a komplementäre Formation. Das zweite wärmeleitende Adapterglied 8 hat eine zu dem Niedertemperatur-Ende 5b komplementäre Formation.

Der thermoelektrische Generator 5 hat einen elektrisch positiven Anschluss 5c und einen elektrisch negativen Anschluss 5d, wobei zwischen dem positiven Anschluss 5c und dem negativen Anschluss 5d ein elektrischer Verbraucher, wie z.B. ein Temperatur-Sensor, ein Druck-Sensor, ein Ventil-Stellantrieb oder ein Akku, geschaltet ist. Als elektrischer Verbraucher kann auch ein Funksender, ein Funkempfänger, ein Sensor, ein Aktuator, ein elektrischer Speicher, ein Spannungswandler oder eine Steuerungsschaltung verwendet werden.

Insbesondere ist der Sensor ein Temperatursensor und/oder ein Drucksensor.

Die Vorrichtung 1 enthält auch ein Ventil 20, das in der Vorlaufleitung 3 oder in der Rücklaufleitung 4 geschaltet ist.

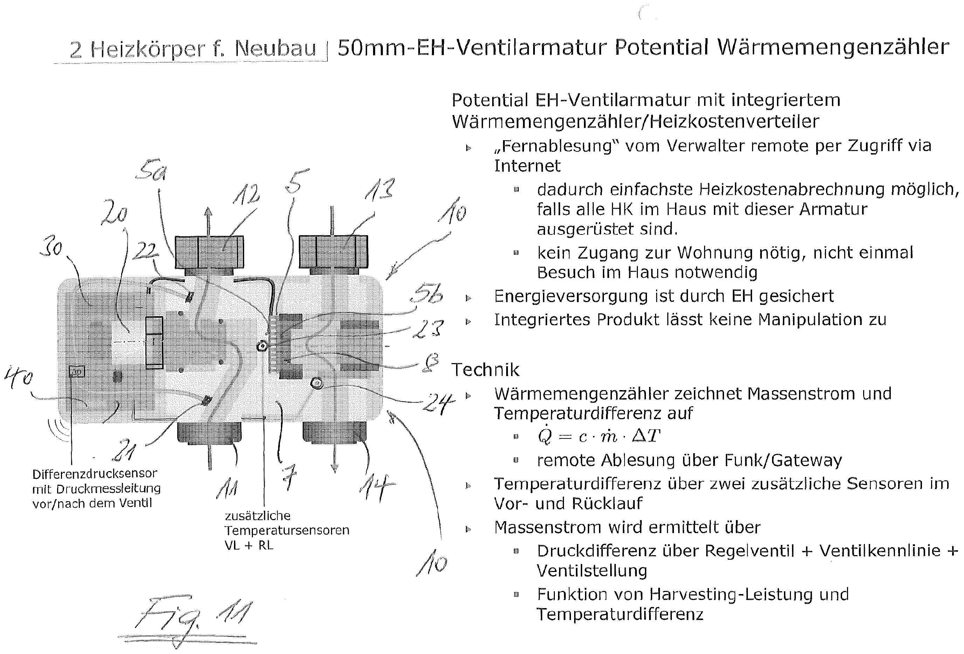

Gemäss **Fig. 11** ist der thermoelektrische Generator 5 in eine Baueinheit 10 integriert, welche einen Vorlauf-Einlassanschluss 11, einen Vorlauf-Auslassanschluss 12, einen Rücklauf-Einlassanschluss 13 und einen Rücklauf-Auslassanschluss 14 aufweist. Die Baueinheit 10 ist mittels ihrer Anschlüsse 11, 12 in der Vorlaufleitung 3 und mittels ihrer Anschlüsse 13, 14 in der Rücklaufleitung 4 geschaltet. In der Baueinheit 10 ist ein Ventil 20 integriert.

Zwischen dem Vorlauf-Einlassanschluss 11 und dem Ventil 20 ist ein erster Drucksensor 21 angeordnet, welcher den Druck stromauf vom Ventil 20 im Vorlauf erfasst. Zwischen dem Ventil 20 und dem Vorlauf-Auslassanschluss 12 ist ein zweiter Drucksensor 22 angeordnet, welcher den Druck stromab vom Ventil 20 im Vorlauf erfasst. Aus der Druckdifferenz, d.h. dem Druckabfall am Ventil 20, kann der Massenfluss **dm/dt** des Wärmeträgerfluids im Vorlauf bestimmt werden, nachdem der Massenfluss als Funktion des Druckabfalls für verschiedene Ventil-Einstellungen kalibriert worden ist (Ventil-Kennlinie).

Zwischen dem Vorlauf-Einlassanschluss 11 und dem Vorlauf-Auslassanschluss 12 ist ein erster Temperatursensor 23 angeordnet, welcher die Temperatur **T_{VL}** im Vorlauf erfasst. Zwischen dem Rücklauf-Einlassanschluss 13 und dem Rücklauf-Auslassanschluss 14 ist ein zweiter Temperatursensor 24 angeordnet, welcher die Temperatur **T_{RL}** im Rücklauf erfasst.

Aus dem momentanen Massenstrom dm/dt, der momentanen Temperaturdifferenz T_{VL}-T_{RL} und der spezifischen Wärmekapazität c des Wärmeträgerfluids (z.B. Wasser) kann der momentane Wärmestrom dQ/dt der Heizleistung in der Vorrichtung 1 bestimmt werden: dQ/dt = c (T_{VL}-T_{RL}) dm/dt

Analog kann aus dem momentanen Massenstrom dm/dt, der momentanen Temperaturdifferenz T_{RL}-T_{VL} und der spezifischen Wärmekapazität c des Wärmeträgerfluids (z.B. Wasser) der momentane Wärmestrom dQ/dt der Kühlleistung in der Vorrichtung 1 bestimmt werden: dO/dt = c (T_{RL}-T_{VL}) dm/dt

Durch Integration können dann aus dem Wärmestrom der Heizleistung oder aus dem Wärmestrom der Kühlleistung die kumulierten Wärmemengen für das Heizen bzw. das Kühlen gewonnen werden. Diese Daten können vor Ort in der Baueinheit 10, welche der Vorrichtung 1 zum Heizen oder Kühlen zugeordnet ist, in einem Datenspeicher 30 gespeichert werden. Die Baueinheit 10 enthält ausserdem eine Funkeinheit 40 mit einem Sender und einem Empfänger, über welche die Wärmemengen-Daten per Funk aus dem Datenspeicher 30 abgerufen werden können. Diese Fernablesung ermöglicht eine starke Vereinfachung des Prozesses der Heiz/Kühl-Kostenabrechnung.

### Bezugszeichen:

1. Vorrichtung zum Heizen und/oder Kühlen
2. durchströmbarer Körper
3. Vorlaufleitung
3a Vorlauf-Teilabschnitt
4. Rücklaufleitung
4a Rücklauf-Teilabschnitt
5. thermoelektrischer Generator
6. thermoelektrischer Generator
5a Hochtemperatur-Ende
6a Hochtemperatur-Ende
5b Niedertemperatur-Ende
6b Niedertemperatur-Ende
7. wärmeleitendes Adapterglied
8. wärmeleitendes Adapterglied
10.Baueinheit
11.Anschluss
12.Anschluss
13.Anschluss
14.Anschluss
20.Ventil
21.erster Drucksensor (Druck stromauf vom Ventil)
22.zweiter Drucksensor (Druck stromab vom Ventil)
23.erster Temperatursensor (Temperatur im Vorlauf)
24.zweiter Temperatursensor (Temperatur im Rücklauf)
30.Datenspeicher
40.Funkeinheit

## Patentansprüche

1. Vorrichtung (1) zum Heizen oder Kühlen eines Wohnraumes, mit einem von einem Wärmeträgerfluid, vorzugsweise Wasser, durchströmbaren Körper (2), welcher eine Vorlaufleitung (3) zum Einleiten von Wärmeträgerfluid in den Körper sowie eine Rücklaufleitung (4) zum Ausleiten von Wärmeträgerfluid aus dem Körper (2) aufweist, wobei die Vorrichtung (1) mindestens einen thermoelektrischen Generator (5) mit einem Hochtemperatur-Ende (5a) und einem Niedertemperatur-Ende (5b) aufweist, wobei der mindestens eine thermoelektrische Generator (5) zwischen der Vorlaufleitung (3) und der Rücklaufleitung (4) geschaltet ist, wobei das Hochtemperatur-Ende (5a) des thermoelektrischen Generators (5) mit der Vorlaufleitung (3) in thermischem Kontakt ist und das Niedertemperatur-Ende (5b) des thermoelektrischen Generators (5) mit der Rücklaufleitung (4) in thermischem Kontakt ist, wobei der mindestens eine thermoelektrische Generator (5) einen elektrisch positiven Anschluss (5c) und einen elektrisch negativen Anschluss (5d) aufweist, wobei zwischen dem positiven Anschluss (5c) und dem negativen Anschluss (5d) mindestens ein elektrischer Verbraucher geschaltet ist, **dadurch gekennzeichnet, dass** als der mindestens eine elektrische Verbraucher ein Sensor verwendet wird, wobei der Sensor einer Drucksensor und/oder einen Temperatursensor umfasst.

2. Vorrichtung (1) nach Anspruch 1, **dadurch gekennzeichnet, dass** die Vorrichtung (1) einen weiteren thermoelektrischen Generator aufweist, dessen Hochtemperatur-Ende mit der Rücklaufleitung (4) in thermischem Kontakt ist und dessen Niedertemperatur-Ende mit der Vorlaufleitung (3) in thermischem Kontakt ist.

3. Vorrichtung (1) nach einem der Ansprüche 1 oder 2, **dadurch gekennzeichnet, dass** die Vorlaufleitung (3) einen Vorlauf-Teilabschnitt (3a) aufweist und die Rücklaufleitung (4) einen Rücklauf-Teilabschnitt (4a) aufweist, wobei der mindestens eine thermoelektrische Generator (5) zwischen dem Vorlauf-Teilabschnitt (3a) und dem Rücklauf-Teilabschnitt (4a) geschaltet ist.

4. Vorrichtung (1) nach Anspruch 3, **dadurch gekennzeichnet, dass** der Vorlauf-Teilabschnitt (3a) und der Rücklauf-Teilabschnitt (4a) voneinander einen kleineren Abstand haben als andere Abschnitte der Vorlaufleitung (3) und der Rücklaufleitung (4) voneinander.

5. Vorrichtung (1) nach Anspruch 3 oder 4, **dadurch gekennzeichnet, dass** zwischen dem Vorlauf-Teilabschnitt (3a) und dem thermoelektrischen Generator (5) ein erstes wärmeleitendes Adapterglied (7) in thermischer Kopplung angeordnet ist und zwischen dem Rücklauf-Teilabschnitt (4a) und dem thermoelektrischen Generator (5) ein zweites wärmeleitendes Adapterglied (8) in thermischer Kopplung angeordnet ist.

6. Vorrichtung (1) nach Anspruch 5, **dadurch gekennzeichnet, dass** das erste und/oder das zweite wärmeleitende Adapterglied (7, 8) in einer seiner Abmessungen längenverstellbar ist.

7. Vorrichtung (1) nach Anspruch 5 oder 6, **dadurch gekennzeichnet, dass** der Vorlauf-Teilabschnitt (3a) eine Vorlauf-Formation aufweist und das erste wärmeleitende Adapterglied (7) eine zu der Vorlauf-Formation komplementäre erste Adapter-Formation aufweist, und dass der Rücklauf-Teilabschnitt (4a) eine Rücklauf- Formation aufweist und das zweite wärmeleitende Adapterglied (8) eine zu der Rücklauf-Formation komplementäre zweite Adapter-Formation aufweist.

8. Vorrichtung (1) nach einem der Ansprüche 5 bis 7, **dadurch gekennzeichnet, dass** das erste wärmeleitende Adapterglied (7) eine zu dem Hochtemperatur-Ende (5a) komplementäre Formation (Z1) aufweist, und dass das zweite wärmeleitende Adapterglied (8) eine zu dem Niedertemperatur-Ende (5b) komplementäre Formation (Z2) aufweist.

9. Vorrichtung (1) nach einem der vorherigen Ansprüche, **dadurch gekennzeichnet, dass** als mindestens ein elektrischer Verbraucher zusätzlich zu dem Sensor mindestens eines der folgenden Elemente verwendet wird: ein Funksender, ein Funkempfänger, ein Aktuator, ein elektrischer Speicher, ein Spannungswandler oder eine Steuerungsschaltung.

10. Vorrichtung (1) nach einem der vorherigen Ansprüche, **dadurch gekennzeichnet, dass** die Vorrichtung (1) ein Ventil (20) aufweist, das in der Vorlaufleitung (3) oder in der Rücklaufleitung (4) geschaltet ist.

11. Vorrichtung (1) nach einem der vorherigen Ansprüche, umfassend eine Baueinheit (10), wobei der thermoelektrische Generator (5) in die Baueinheit (10) integriert ist, und wobei die Baueinheit (10) einen Vorlauf-Einlassanschluss (11), einen Vorlauf-Auslassanschluss (12), einen Rücklauf-Einlassanschluss (13) und einen Rücklauf-Auslassanschluss (14) aufweist, wobei die Baueinheit (10) mittels ihrer Anschlüsse (11, 12, 13, 14) in der Vorlaufleitung (3) und in der Rücklaufleitung (4) geschaltet ist.

12. Vorrichtung (1) nach Anspruch 10 und 11, **dadurch gekennzeichnet, dass** das Ventil (20) ir die Baueinheit (10) integriert ist.

## Claims

1. Device (1) for heating or cooling a living space, having a body (2) which can be flowed through by a heat transfer fluid, preferably water, and which comprises a feed line (3) for the introduction of heat transfer fluid into the body and a return line (4) for the discharge of heat transfer fluid out of the body (2), wherein the device (1) comprises at least one thermoelectric generator (5) with a high-temperature end (5a) and a low-temperature end (5b), wherein the at least one thermoelectric generator (5) is connected between the feed line (3) and the return line (4), wherein the high-temperature end (5a) of the thermoelectric generator (5) is in thermal contact with the feed line (3) and the low-temperature end (5b) of the thermoelectric generator (5) is in thermal contact with the return line (4), wherein the at least one thermoelectric generator (5) comprises an electrically positive terminal (5c) and an electrically negative terminal (5d), wherein at least one electrical load is connected between the positive terminal (5c) and the negative terminal (5d), **characterized in that** a sensor is used as the at least one electrical load, wherein the sensor comprises a pressure sensor and/or a temperature sensor.

2. Device (1) according to Claim 1, **characterized in that** the device (1) comprises a further thermoelectric generator, the high-temperature end of which is in thermal contact with the return line (4) and the low-temperature end of which is in thermal contact with the feed line (3).

3. Device (1) according to either of Claims 1 and 2, **characterized in that** the feed line (3) comprises a feed subsection (3a) and the return line (4) comprises a return subsection (4a), wherein the at least one thermoelectric generator (5) is connected between the feed subsection (3a) and the return subsection (4a).

4. Device (1) according to Claim 3, **characterized in that** the feed subsection (3a) and the return subsection (4a) are at a smaller distance from one another than the other sections of the feed line (3) and the return line (4) are from one another.

5. Device (1) according to Claim 3 or 4, **characterized in that** a first heat-conducting adapter element (7) is arranged in thermal coupling between the feed subsection (3a) and the thermoelectric generator (5) and a second heat-conducting adapter element (8) is arranged in thermal coupling between the return subsection (4a) and the thermoelectric generator (5).

6. Device (1) according to Claim 5, **characterized in that** the first and/or the second heat-conducting adapter element (7, 8) is adjustable in length in one of its dimensions.

7. Device (1) according to Claim 5 or 6, **characterized in that** the feed subsection (3a) comprises a feed formation and the first heat-conducting adapter element (7) comprises a first adapter formation complementary to the feed formation, and **in that** the return subsection (4a) comprises a return formation and the second heat-conducting adapter element (8) comprises a second adapter formation complementary to the return formation.

8. Device (1) according to one of Claims 5 to 7, **characterized in that** the first heat-conducting adapter element (7) comprises a formation (Z1) complementary to the high-temperature end (5a), and **in that** the second heat-conducting adapter element (8) comprises a formation (Z2) complementary to the low-temperature end (5b).

9. Device (1) according to one of the preceding claims, **characterized in that**, in addition to the sensor, at least one of the following elements is used as the at least one electrical load: a radio transmitter, a radio receiver, an actuator, an electrical storage, a voltage transformer or a control circuit.

10. Device (1) according to one of the preceding claims, **characterized in that** the device (1) comprises a valve (20), which is connected in the feed line (3) or in the return line (4).

11. Device (1) according to one of the preceding claims, including a structural unit (10), wherein the thermoelectric generator (5) is integrated in the structural unit (10), and wherein the structural unit (10) comprises a feed inlet connection (11), a feed outlet connection (12), a return inlet connection (13) and a return outlet connection (14), wherein the structural unit (10) is connected by means of its connections (11, 12, 13, 14) in the feed line (3) and in the return line (4).

12. Device (1) according to Claims 10 and 11, **characterized in that** the valve (20) is integrated in the structural unit (10).

## Revendications

1. Dispositif (1) permettant de chauffer ou de refroidir une pièce à vivre, comprenant un corps (2) pouvant être traversé par un fluide caloporteur, de préférence de l'eau, et qui présente une conduite d'aller (3) pour introduire un fluide caloporteur dans le corps ainsi qu'une conduite de retour (4) pour évacuer un fluide caloporteur du corps (2), dans lequel le dispositif (1) présente au moins un générateur thermoélectrique (5) pourvu d'une extrémité haute température (5a) et d'une extrémité basse température (5b), dans lequel ledit au moins un générateur thermoélectrique (5) est inséré entre la conduite d'aller (3) et la conduite de retour (4), dans lequel l'extrémité haute température (5a) du générateur thermoélectrique (5) est en contact thermique avec la conduite d'aller (3) et l'extrémité basse température (5b) du générateur thermoélectrique (5) est en contact thermique avec la conduite de retour (4), dans lequel ledit au moins un générateur thermoélectrique (5) présente une connexion électriquement positive (5c) et une connexion électriquement négative (5d), dans lequel au moins un consommateur électrique est connecté entre la connexion positive (5c) et la connexion négative (5d),
**caractérisé en ce qu'**un capteur est utilisé comme ledit au moins un consommateur électrique, le capteur comprenant un capteur de pression et/ou un capteur de température.

2. Dispositif (1) selon la revendication 1, **caractérisé en ce que** le dispositif (1) présente un autre générateur thermoélectrique dont l'extrémité haute température est en contact thermique avec la conduite de retour (4) et dont l'extrémité basse température est en contact thermique avec la conduite d'aller (3).

3. Dispositif (1) selon l'une quelconque des revendications 1 et 2, **caractérisé en ce que** la conduite d'aller (3) présente un tronçon d'aller (3a) et la conduite de retour (4) présente un tronçon de retour (4a), dans lequel ledit au moins un générateur thermoélectrique (5) est connecté entre le tronçon d'aller (3a) et le tronçon de retour (4a).

4. Dispositif (1) selon la revendication 3, **caractérisé en ce que** le tronçon d'aller (3a) et le tronçon de retour (4a) présentent une distance l'un par rapport à l'autre qui est inférieure à celle des autres sections de la conduite d'aller (3) et de la conduite de retour (4) les unes par rapport aux autres.

5. Dispositif (1) selon la revendication 3 ou 4, **caractérisé en ce qu'**un premier élément d'adaptation thermoconducteur (7) est disposé en couplage thermique entre le tronçon d'aller (3a) et le générateur thermoélectrique (5), et un deuxième élément d'adaptation thermoconducteur (8) est disposé en couplage thermique entre le tronçon de retour (4a) et le générateur thermoélectrique (5).

6. Dispositif (1) selon la revendication 5, **caractérisé en ce que** le premier élément et/ou le deuxième élément d'adaptation thermoconducteur(s) (7, 8) est/sont réglable(s) en longueur au niveau d'une des dimensions de celui-ci/ceux-ci.

7. Dispositif (1) selon la revendication 5 ou 6, **caractérisé en ce que** le tronçon d'aller (3a) présente une structure d'aller, et le premier élément d'adaptation thermoconducteur (7) présente une première structure d'adaptation complémentaire à la structure d'aller, et **en ce que** le tronçon de retour (4a) présente une structure de retour et le deuxième élément d'adaptation thermoconducteur (8) présente une structure d'adaptation complémentaire à la structure de retour.

8. Dispositif (1) selon l'une quelconque des revendications 5 à 7, **caractérisé en ce que** le premier élément d'adaptation thermoconducteur (7) présente une structure (Z1) complémentaire à l'extrémité haute température (5a), et **en ce que** le deuxième élément d'adaptation thermoconducteur (8) présente une formation (Z2) complémentaire à l'extrémité basse température (5b).

9. Dispositif (1) selon l'une quelconque des revendications précédentes, **caractérisé en ce qu'**en plus du capteur, au moins l'un des éléments suivants est utilisé comme ledit au moins un consommateur électrique : un émetteur radio, un récepteur radio, un actionneur, un accumulateur électrique, un transformateur de tension ou un circuit de commande.

10. Dispositif (1) selon l'une quelconque des revendications précédentes, **caractérisé en ce que** le dispositif (1) présente une vanne (20) qui est connectée dans la conduite d'aller (3) ou dans la conduite de retour (4).

11. Dispositif (1) selon l'une quelconque des revendications précédentes, comprenant une unité modulaire (10), dans lequel le générateur thermoélectrique (5) est intégré dans l'unité modulaire, et dans lequel l'unité modulaire (10) présente une connexion d'entrée d'aller (11), une connexion de sortie d'aller (12), une connexion d'entrée de retour (13) et une connexion de sortie de retour (14), dans lequel l'unité modulaire (10) est connectée au moyen de ses connexions (11, 12, 13, 14) dans la conduite d'aller (3) et dans la conduite de retour (4).

12. Dispositif (1) selon la revendication 10 et 11, **caractérisé en ce que** la vanne (20) est intégrée dans l'unité modulaire (10).
